(19) **Europäisches Patentamt / European Patent Office / Office européen des brevets**

(11) **EP 2 154 573 A1**

(12) **EUROPEAN PATENT APPLICATION**
published in accordance with Art. 153(4) EPC

(43) Date of publication:
**17.02.2010 Bulletin 2010/07**

(51) Int Cl.:
***G03F 7/20*** *(2006.01)*

(21) Application number: **08775425.5**

(22) Date of filing: **04.06.2008**

(86) International application number:
**PCT/ES2008/000397**

(87) International publication number:
**WO 2008/148909 (11.12.2008 Gazette 2008/50)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **05.06.2007 ES 200701546**

(71) Applicant: **Centro De Estudios E Investigaciones Técnicas De Guipuzcoa (CEITG)**
**20018 San Sebastián (Guipuzcoa) (ES)**

(72) Inventors:
• **KONSTANTINOVICH VEREVKIN, Yury**
**603950 Nizhny Novgorod (RU)**

• **NIKOLAEVICH PETRYKOV, Vladimir**
**603950 Nizhny Novgorod (RU)**
• **RODRIGUEZ GONZÁLEZ. Ainara**
**E-20018 San Sebastián (ES)**
• **OLAIZOLA IZQUIERDO, Santiago Miguel**
**E-20018 San Sebastián (ES)**
• **AYERDI OLAIZOLA, Isabel**
**E-20018 San Sebastián (ES)**
• **PENG, Changsi**
**33720 TAMPERE (FI)**
• **TAN, Chunlei**
**33720 TAMPERE (FI)**
• **PESSA, Markus**
**33720 TAMPERE (FI)**

(74) Representative: **Cabinet Plasseraud**
**52, rue de la Victoire**
**75440 Paris Cedex 09 (FR)**

(54) **SYSTEM FOR LITHOGRAPHY BY LASER INTERFERENCE**

(57) The invention relates to a system for lithography by laser interference, according to which laser radiation (1) is applied by means of high-power impulses, said radiation splitting into beams which are then recombined by reflection for the incidence thereof on the application material (2), with configuration parameters, in order to define large-surface templates during a single pass over the material (2).

Fig. 1

**Description**

Field of the Art

The present invention relates to the field of lithography by laser interference, proposing the use of a radiation of high-power impulses, which enables creating periodic or quasi-periodic structures, at nanoscale, on any material from photosensitive resins to single-crystal materials such as diamond or silicon, such that the high temperatures which are achieved allow using non-linear modification regimes in areas with size of up to about one tenth of the wavelength of the radiation which is being used.

State of the Art

Lithography by laser interference is a known technique which is used for structuring elements on resins by means of printing templates which are generated by making coherent beams impinge on the application material, which coherent beams arise from the splitting of a laser beam and the recombination of the split beams, with certain configuration parameters.

Known systems for lithography by laser interference, in this sense, such as those of patents US 5 771 098, US 6 304 318 and US 6 882 477, use a laser with continuous wave output radiation, having drawbacks such as:

- Need for a long time of exposure on photosensitive resins to obtain a contrast structure, which requires a high stability with respect to the vibration.
- The radiation power used only allows simultaneously registering structures in very reduced areas, the amplification of the radiation power not being possible and therefore the creation of structures in larger areas requires using complex devices for scanning the entire surface of the samples with the necessary precision.
- The application of modifications by interference with this type of radiation can only be used with high-sensitivity materials (photosensitive resins).

Object of the Invention

According to the invention, a system for lithography by laser interference is proposed, using a radiation by impulses, the application of which is developed by breaking down the radiation used, by means of splitters, into multiple beams, which are then recombined by reflection with mirrors and the incorporation of configuration parameters, on the application material, in order to form the desired interference template.

With this system for lithography by impulses, the radiation energy can be increased up to a few tenths of Joules, being able to obtain lithography structures in areas of up to 1000 square centimeters on photosensitive resins; whereas for a smaller area and radiation energy density of about 1 $J/cm^2$, the conditions of non-linear modification at nanoscale for any material in regions with sizes of up to about one tenth of the wavelength of the radiation used occur.

The method of the invention thus allows locating the laser energy in a large set of areas with sizes less than 100 nm, obtaining temperatures greater than a few thousands of degrees centigrade in a scale of this type or a threshold of modification of the application material, and thus the implementation of non-linear mechanisms of modification at nanoscale on a large variety of materials.

The use of a radiation by means of high-power impulses for creating interference structures, with an impulse duration less than 10 ns, furthermore significantly reduces the mechanical stability requirements of the laser configuration for the performance of the lithography.

The method of the invention, based on the application of a radiation by impulses, for structuring materials by means of lithography by laser beam interference consequently provides the following advantages:

- Possibility of modifying materials by means of non-linear interaction.
- Possibility of applying a high-power radiation to modify areas of up to 1000 $cm^2$.
- Little dependence of the optical scheme used with respect to the external conditions (temperature, etc.) for the results of the modification.
- Requirements which are not very relevant in relation to the mechanical vibration.
- Capacity to modify virtually any material.
- Suitability both for the direct modification or writing of the application materials and for the "exposure and developing" process.
- Possibility of orienting templates for structuring materials in multiple layers and in 3D by means of the precise control of the phase of each of the beams using phase difference techniques such as piezoelectric elements.
- Possibility of controlling the processes of self-organization of two-dimensional quantum points with dimensions less than 20 nm.

Therefore, the system of the invention has truly advantageous features, acquiring its own identity and a preferred character for the lithography function for which it is intended.

Description of the Drawings

Figure 1 shows a diagram of the application of the proposed system for lithography.
Figure 2 shows a diagram of the piezoelectric positioner of mirrors for controlling the phase difference between the beams.

Figure 3A shows the results of the process of a material, showing by way of example the structuring induced by the processing by means of the system of the invention.

Figure 3B is an enlarged detail of one of the structured areas of the previous figure.

Detailed Description of the Invention

The object of the invention relates to a system for lithography by laser beam interference, using a radiation (1) by impulses, which is applied through splitters which split it into beams, which are reflected by mirrors in a recombination of projection towards the material (2) to be structured by the lithographic action.

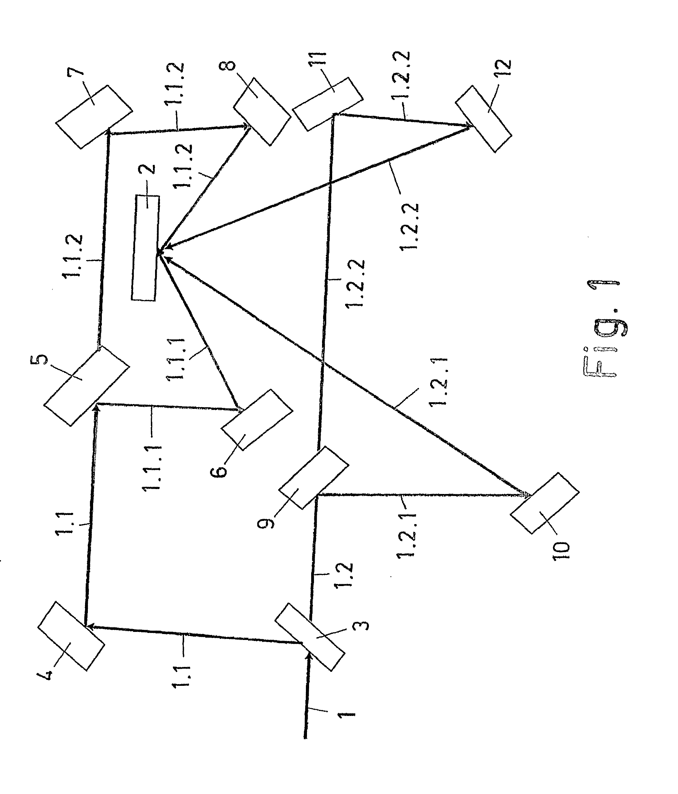

According to the example depicted in Figure 1, the radiation (1) intended for the lithographic action is projected through a splitter (3) which splits it into two beams (1.1 and 1.2) following different directions.

One of the resulting beams (1.1) is reflected by means of a mirror (4) towards another splitter (5), which splits it into two other beams (1.1.1 and 1.1.2), the first of which is reflected by a mirror (6) directly towards the material (2) to be structured, whereas the second beam (1.1.2) is successively reflected by respective mirrors (7) and (8), also for the incidence thereof on the material (2) to be structured.

The second beam (1.2) of the first splitting is in turn split by another splitter (9) into respective beams (1.2.1 and 1.2.2), the first of which is reflected by a mirror (10) directly towards the material (2) to be structured, whereas the second beam (1.2.2) is successively reflected by respective mirrors (11) and (12), also for the incidence thereof on the material (2) to be structured.

There is thus a splitting of the original laser projection (1), by means of successive splittings, into four beams (1.1.1, 1.1.2, 1.2.1 and 1.2.2), which are finally recombined in common incidence on the material (2) to be structured.

The recombination of the incident beams on the material (2) to be structured is carried out with the incorporation of configuration parameters, such as the angle of incidence, the polarization, or the phase thereof, thus determining the structuring templates and therefore the shape of the structures to be made on the application material (2). The system likewise includes a subsystem formed by piezoelectric positioners to move with nanometric precision the application material (2) in the three spatial dimensions.

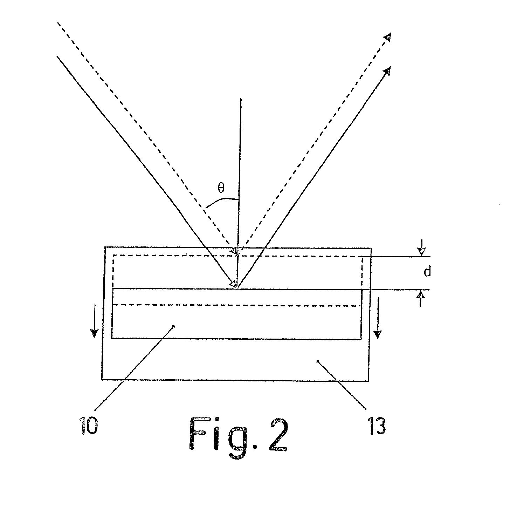

The control of the phase difference between the incident beams has a special importance for the formation of different templates. The phase difference is controlled by means of piezoelectric positioners in one dimension, which are placed by acting on the mirrors directing three of the four beams, for example in the mirrors (6, 8 and 10). The control of the phase difference is achieved upon varying the optical path of one of these three beams with respect to the fourth beam at nanometric scale, as observed in Figure 2. The beam which is varied is impinged on the corresponding mirror, for example the mirror (10), the position of which is controlled by a piezoelectric actuator (13). As there is a displacement (d) in the position of the mirror, there is an increase in the optical path of the beam $\Delta L$ which depends on the displacement (d) of the mirror and on the angle of incidence of the beam ($\theta$) according to the expression $\Delta L = 2d/\cos\theta$. The variation in the phase of the beam $\Delta\varphi$ at a point of the path of the beam behind the mirror will therefore be $\Delta\varphi = 2\pi^* \Delta L/\lambda$, $\lambda$ being the wavelength of the incident beam.

The periodic or quasi-periodic structures, with sizes less than 100 nm, arise in the region of the overlap of the beams which are impinged on the application material (2), such that the use of a high-power radiation (1) by impulses (with an impulse duration less than 10 ns), for the creation of interference structures, significantly reduces the requirements demanded from the mechanical stability of the laser configuration.

The system furthermore assures the minimum influence of temperature variations and other fluctuations in the external conditions of the modifications of materials at nanoscale.

The intensity of the radiation (1) to be applied depends on the combination:

$$\Phi_0 = \Phi_1 + \Phi_2 - \Phi_3 - \Phi_4$$

where:

$\Phi_1$ = phase of the beam (1.1.1).
$\Phi_2$ = phase of the beam (1.1.2).
$\Phi_3$ = phase of the beam (1.2.1).
$\Phi_4$ = phase of the beam (1.2.2).

According to which, the system has the capacity to increase the energy of the impulses to values (approximately 20 Joules) which are necessary for the creation of structures in areas of up to 1000 $cm^2$, the laser energy being able to be located in a set of areas with sizes less than 100 nm, temperatures greater than several thousands of degrees centigrade in a scale of this type or a threshold of modification of the application material, and the implementation of non-linear mechanisms of modification at nanoscale, for a large variety of materials, being obtained.

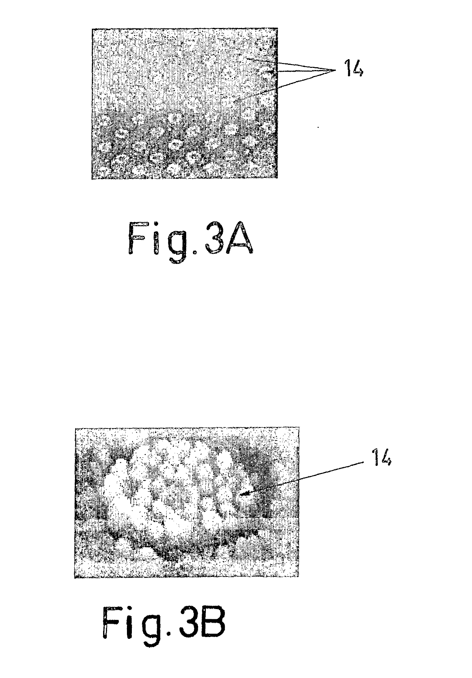

By way of example, Figures 3A and 3B show the results of the processing of a material by means of the system of the invention, structures (14) (of 8 nm) generated by means of high-energy laser impulses being able to be observed.

**Claims**

1.  A system for lithography by laser interference, of the type which etches on an application material an interference template generated upon making several coherent laser beams impinge on it, **characterized in that** it applies a laser radiation (1) by means of high-power impulses, which is split into beams which are then recombined in incidence on the application material (2), together with the incorporation of configuration parameters, in order to define large-surface templates during a single pass over any type of material (2) .

2.  The system for lithography by laser interference according to claim 1, **characterized in that** the laser radiation (1) by impulses is applied through a splitter (3) determining two beams (1.1 and 1.2), which are in turn split, by means of respective splitters (5 and 9), into other beams (1.1.1, 1.1.2, 1.2.1 and 1.2.2), which are recombined by reflection in incidence towards the application material (2).

3.  The system for lithography by laser interference according to claim 2, **characterized in that** the course of the beams (1.1 and 1.2) resulting from the splitting of the laser radiation (1) by impulses is determined with one and the same number of reflections, which can reflect two different wavelengths, to the projection of incidence on the application material (2), conferring stability to the interference template.

4.  The system for lithography by laser interference according to claim 1, **characterized in that** the recombination by reflection of high-energy beams on the application material (2) generates thereon non-linear mechanisms of modification in the interference template.

5.  The system for lithography by laser interference according to claim 1, **characterized by** a system for controlling the phase difference between the incident beams, formed by piezoelectric elements, conferring nanometric 3D precision to the definition of the interference templates.

6.  The system for lithography by laser interference according to claim 1, **characterized by** systems for controlling the phase difference between the incident beams and the displacement of the sample, formed by piezoelectric elements which enable applying one or more additional exposures spatially offset from the first one to obtain a high density of geometric motifs on the sample.

Fig. 1

θ

d

10

Fig. 2

13

Fig.3A

Fig.3B

# INTERNATIONAL SEARCH REPORT

| | International application No. |
| --- | --- |
| | PCT/ ES 2008/000397 |

### A. CLASSIFICATION OF SUBJECT MATTER

*G03F 7/20* (2006.01)

According to International Patent Classification (IPC) or to both national classification and IPC

### B. FIELDS SEARCHED

Minimum documentation searched (classification system followed by classification symbols)

G03F, B23K

Documentation searched other than minimum documentation to the extent that such documents are included in the fields searched

Electronic data base consulted during the international search (name of data base and, where practicable, search terms used)

INVENES, EPODOC, WPI, INSPEC

### C. DOCUMENTS CONSIDERED TO BE RELEVANT

| Category* | Citation of document, with indication, where appropriate, of the relevant passages | Relevant to claim No. |
| --- | --- | --- |
| E | US 2008/0129973 A1 (McCAFFERTY, D. et al.) 05.06.2008, abstract; paragraphs [0002], [0006], [0008]-[0011], [0022]-[0032], [0036]-[0038]; figures 1-3, 9, 10A and 10B. | 1, 2, 5, 6 |
| X | US 2005/0064297 A1 (WAGO, K.) 24.03.2005, abstract; paragraphs [0010], [0011], [0015]-[0018], | 1, 2, 5, 6 |
| A | [0025]-[0029], [0034], [0035], [0044]-[0050], [0052]; figures 1 and 2. | 3 |
| X | WO 2004/003611 A1 (AUSTRALIAN PHOTONICS PTY LTD. et al.) 08.01.2004, | 1, 2, 5, 6 |
| A | abstract; page 2, line 14 - page 6, line 27; page 8, line 15 - page 9, line 8; page 9, lines 23-27; page 10, lines 7-29; page 12, line 3 - page 13, line 3; figures 1, 2 and 5. | 3, 4 |

☒ Further documents are listed in the continuation of Box C.        ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | |
| | "&" document member of the same patent family |

| Date of the actual completion of the international search | Date of mailing of the international search report |
| --- | --- |
| 29.October.2008        (29.10.2008) | **(03/11/2008)** |
| Name and mailing address of the ISA/ O.E.P.M. Paseo de la Castellana, 75 28071 Madrid, España. Facsimile No.   34 91 3495304 | Authorized officer O. González Peñalba Telephone No. +34 91 349 54 75 |

Form PCT/ISA/210 (second sheet) (July 2008)

## INTERNATIONAL SEARCH REPORT

| | International application No. |
|---|---|
| | PCT/ES 2008/000397 |

| C (continuation). | DOCUMENTS CONSIDERED TO BE RELEVANT | |
|---|---|---|
| Category* | Citation of documents, with indication, where appropriate, of the relevant passages | Relevant to claim No. |
| A | WO 02/069051 A2 (OPTICAL SWITCH CORPORATION) 06.09.2002. | |

Form PCT/ISA/210 (continuation of second sheet) (July 2008)

## INTERNATIONAL SEARCH REPORT

Information on patent family members

| International application No. |
| PCT/ ES 2008/000397 |

| Patent document cited in the search report | Publication date | Patent family member(s) | Publication date |
|---|---|---|---|
| US 2008129973 A | 05.06.2008 | JP 2008160085 A | 10.07.2008 |
| | | | 10.07.2008 |
| | | | 10.07.2008 |
| US 2005064297 A | 24.03.2005 | US 2008124658 A | 29.05.2008 |
| | | | 29.05.2008 |
| | | | 29.05.2008 |
| WO 2004003611 A | 08.01.2004 | CA 2530777 A | 08.01.2004 |
| | | AU 2003237567 A | 19.01.2004 |
| | | EP 1540393 A | 15.06.2005 |
| | | EP 20030735149 | 27.06.2003 |
| | | JP 2005531797 T | 20.10.2005 |
| | | KR 20060015415 A | 17.02.2006 |
| | | US 2006125913 A | 15.06.2006 |
| | | EP 1818699 A | 15.08.2007 |
| | | EP 20070107009 | 27.06.2003 |
| WO 02069051 A | 06.09.2002 | US 2002149849 A | 17.10.2002 |
| | | US 6522433 B | 18.02.2003 |

Form PCT/ISA/210 (patent family annex) (July 2008)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5771098 A
- US 6304318 B
- US 6882477 B